# EUROPEAN PATENT APPLICATION

(11) **EP 2 565 947 A2**
(43) Date of publication of application: **06.03.2013**
(21) Application number: 12167156.4
(22) Date of filing: 08.05.2012
(51) Int. Cl.: H01L 33/50

(54) **Light-emitting device and illumination device using same**

(30) Priority: 25.05.2011 JP 2011116464
(71) Applicant: Panasonic Corporation, Osaka 571-8501 (JP)
(72) Inventor: Kume, Rei, Osaka (JP)
(74) Representative: Rüger, Barthelt & Abel

(57) **Abstract**

[Object] To provide a light-emitting device, using an LED, which hardly causes color unevenness, can distribute light at a wide angle, and also has favorable light use efficiency.

[Means for Settlement] A light-emitting device (1) includes: an LED (2), a board (3), and a wavelength conversion member (4) coating the LED (2) and including a phosphor. The wavelength conversion member (4) has: a first phosphor layer (41) provided around the LED (2) in a manner such as to be located at substantially the same height as that of a top surface of the LED (2); and a second phosphor layer (42) coating the LED (2) and the first phosphor layer (41). The second phosphor layer (42) has higher concentration of the phosphor than the first phosphor layer, and an outer side surface of the first phosphor layer (42) is exposed. As a result, for light irradiated towards immediately above the LED (2), light components of the LED (2) itself are suppressed by the second phosphor layer (42), and for light irradiated laterally from the LED (2), components of light subjected to conversion are reduced by the first phosphor layer (41), which can reduce color unevenness on the whole. Moreover, from the outer side surface of the first phosphor layer 41 exposed to outside, light can be irradiated at a wide angle, providing a favorable light use efficiency.

## Description

### [Field of the Invention]

The present invention relates to a light-emitting device using a solid light-emitting element as a light source and an illumination device using the light-emitting device.

### [Background Art]

A light emitting diode (hereinafter LED) is capable of light emission with low power and high luminance and is used as a light source of various electric devices such as displays and illumination devices. In recent years, in addition to a red LED and a green LED, a blue LED has been put into practical use and combining together the LEDs of these three RGB colors permits emission of light of various colors. Moreover, a so-called white LED is well-known which applies light of the blue LED to a phosphor to output yellow light and mixing together the blue light and the yellow light to generate white light. The white LED is excellent in emission intensity and emission efficiency, and a light-emitting device using this is used for, for example, light-diffusing illumination devices such as a ceiling light and a base light and light-condensing illumination devices such as a down light and a spot light.

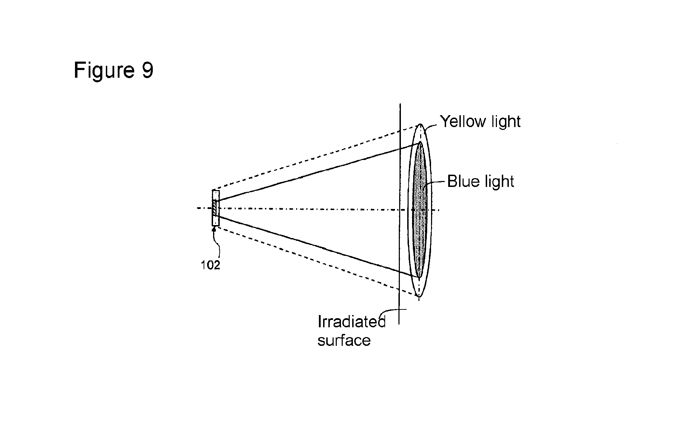

A typical white LED is configured to have a blue LED chip coated with translucent resin containing a yellow phosphor, and thus has a larger region where yellow light is emanated than a region where blue light is emanated (a light-emission surface of the blue LED chip). Thus, as shown in Fig. 9, of light emanated from a white LED 102, the blue light is irradiated to a central region of an irradiated surface and the yellow light is irradiated to a surrounding region, which may cause color unevenness on the irradiated surface.

Thus, well-known is a light-emitting device which has a high-concentration resin layer with high concentration of a yellow phosphor formed on a top surface of an LED, which has a low-concentration resin layer with low concentration of the phosphor formed around the LED, and which increases yellow components of light emanated towards the top surface of the LED to thereby suppress color unevenness (see Patent Document 1).

Moreover, in recent years, a technique has been developed by which a phosphor layer is formed by applying phosphor-containing resin from an ink-jet type nozzle directly to inside of an LED package while controlling an application volume. Then known is a light-emitting device which is manufactured by performing the resin application process with this inkjet in two steps so that emanated light falls within a set given chromaticity range (for example, see Patent Document 2).

### [Conventional Technique Document]

### [Patent Document]

[Patent Document 1] PA 2004-111882
[Patent Document 2] JPA 2009-260244

### [Disclosure of the Invention]

### [Problems to be solved by the Invention]

However, the light-emitting device shown in Patent Document 1 described above has the low-concentration resin layer coated with the high-concentration resin layer. In this configuration, both the blue light transmitted through the low-concentration resin layer and the yellow light subjected to wavelength conversion by the low-concentration resin layer are transmitted through the high-concentration resin layer located on a top surface of the low-concentration resin layer and radiated from the light-emitting device. Thus, a volume of the emanated yellow light subjected to the wavelength conversion when transmitted through the high-concentration resin increases in a direction widening to the surroundings from a light-guide direction of the light-emitting device, causing a risk of color unevenness occurring on the irradiated surface. Moreover, since a cup is provided laterally of the low-concentration resin layer, it is difficult to distribute emanated light at a wide angle.

Moreover, the light-emitting device shown in Patent Document 2 described above has the phosphor layer formed by discharging the phosphor-containing resin into a concave portion of a molded body forming the package; therefore, the molded body lies laterally of the phosphor layer, and as is the case with the above, it is difficult to distribute the emanated light at a wide angle. Moreover, of the light emanated from the LED and the light subjected to the conversion by the phosphor, the light radiated laterally is multi-reflected by the molded body, is not emanated out of the device, and is not used as effective light, resulting in a risk of deterioration in light use efficiency.

The present invention solves the problem described above, and it is an object of the present invention to provide a light-emitting device that hardly causes light unevenness, can distribute emanated light at a wide angle, and also has favorable light use efficiency, and an illumination device using this light-emitting device.

### [Means adapted to solve the Problems]

To solve the problem described above, a light-emitting device according to one aspect of the present invention includes: a solid light-emitting element; a board having the solid light-emitting element mounted thereon; and a wavelength conversion member formed in a manner such as to include a phosphor in a transparent resin member coating a light-emission surface of the solid light-emitting element, wherein the wavelength conversion member has: a first phosphor layer provided around the solid light-emitting element in a manner such as to be located at substantially the same height as that of a top surface of the solid light-emitting element; and a second phosphor layer provided in a manner such as to coat the solid light-emitting element and the first phosphor layer, the second phosphor layer is formed in a manner such as to have higher concentration of the phosphor than the first phosphor layer, and the first phosphor layer is formed in a manner such as to have an outer side surface thereof exposed without being coated with the second phosphor layer.

Preferably, in the light-emitting device described above, the first phosphor layer is formed in a manner such as to slightly cover the top surface of the solid light-emitting element.

Preferably, in the light-emitting device according described above, the wavelength conversion member is formed in a manner such as to be triangular-shaped in a vertical sectional view.

Preferably, the light-emitting device is preferably used for an illumination device.

### [Effects of the Invention]

With the light-emitting device of the present invention, for light irradiated towards immediately above the solid light-emitting element, a light component of the solid light-emitting element itself is suppressed by the second phosphor layer, thereby suppressing color unevenness, and for light irradiated laterally of the solid light-emitting element, a component of light subjected to the conversion is reduced by the first phosphor layer. Therefore, color unevenness can be reduced for the light emanated from the wavelength conversion member on the whole. Moreover, from outer side surfaces of the first phosphor layer exposed to the outside, light can be irradiated at a wide angle, which improves light use efficiency.

### [Brief Description of the Drawings]

[Fig. 1] Fig. 1 is a side sectional view of a light-emitting device according to a first embodiment of the present invention.
[Figs. 2] Figs. 2 (a) to (e) are side sectional views illustrating processes of manufacturing the same light-emitting device.
[Fig. 3] Fig. 3 is a side sectional view of a light-emitting device according to a modified example of the embodiment described above.
[Figs. 4] (Figs. 4 (a) to (e) are side sectional views illustrating processes of manufacturing the light-emitting device according to the modified example described above.
[Figs. 5] Fig. 5 (a) is a side sectional view of a light-emitting device according to another modified example and Fig. 5 (b) is a side sectional view showing a light distribution curve of the same light-emitting device.
[Figs. 6] Fig. 6 (a) is a side sectional view of a light-emitting device according to still another modified example and Fig. 6 (b) is a side sectional view showing a light distribution curve of the same light-emitting device.
[Figs. 7] Fig. 7 (a) is a side sectional view of an illumination device using a light-emitting device according to a second embodiment of the present invention and Fig. 7 (b) is a top view of the same illumination device.
[Figs. 8] Fig. 8 (a) is a side sectional view of an illumination device according to a modified example of the embodiment described above and Fig. 8 (b) is a top view of the same illumination device.
[Fig. 9] Fig. 9 is a diagram illustrating a cause of color unevenness occurring on an irradiated surface in a conventional light-emitting device.

### [Best Modes for Carrying out the Invention]

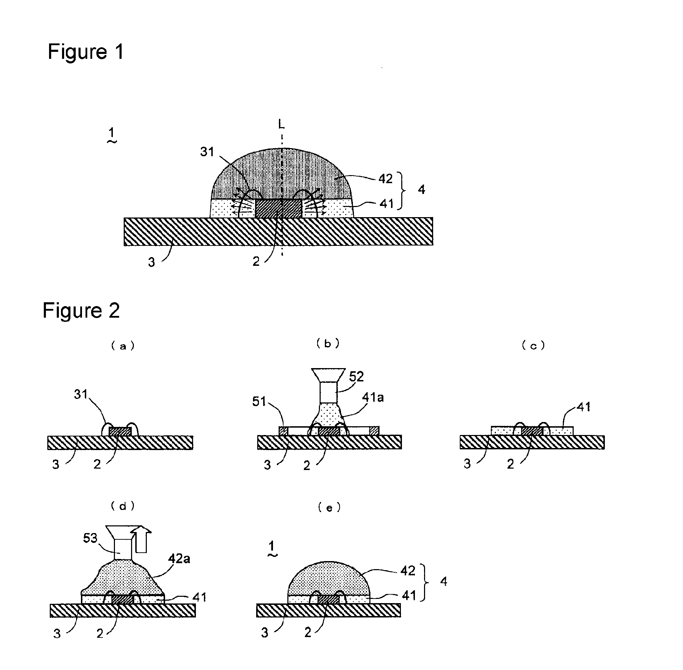

A light-emitting device according to a first embodiment of the present invention will be described with reference to Figs. 1 and 2. The light-emitting device 1 of the present embodiment includes: as shown in Fig. 1, a light-emitting diode (hereinafter referred to as LED) 2 as a solid light-emitting element; a circuit board (hereinafter referred to as board) 3 on which the LED 2 is mounted; and a wavelength conversion member 4 that is so formed as to have a phosphor contained in a transparent resin member coating a light-emission surface of the LED 2. The wavelength conversion member 4 has: a first phosphor layer 41 provided around the LED 2 in a manner such as to be located at substantially the same height as that of a top surface of the LED 2; and a second phosphor layer 42 so provided as to coat the LED 2 and the first phosphor layer 41. A normal line passing through a light-emitting surface of the LED 2 is referred to as a light-guide axis L in the description below.

No limitation is put on the LED 2 as long as it is a light source that permits emission of light of a desired color as the light-emitting device 1, but it is preferable to use a GaN blue LED chip that radiates blue light with a emission peak wavelength of 460 nm. In the present embodiment, used for the LED 2 is a so-called face-up type element having an anode and a cathode provided on an element top surface. The LED 2 is mounted on the board 3 with a submount such as an AIN and each electrode provided on the element top surface of the LED 2 is coupled by use of a wire 31 to a wiring pattern (not shown) provided on the board 3. This electrically connects together the LED 2 and the wiring pattern. Illustrated here as a method of mounting the LED 2 is an example in which the face-up type element is mounted through wire bonding, but the LED 2 may be a face-down type element having electrodes provided on a bottom side, in which case the LED 2 is mounted through, for example, flip-flop mounting.

Used for the board 3 is a ceramic board of alumina or aluminum nitride with excellent performance of releasing heat of the LED 2 or a metal board provided with an insulation layer provided on its surface. Moreover, if output of the LED 2 is small and an amount of heat generation is small, a board plate material formed of, for example, a glass epoxy resin or a paper phenol resin is preferably used. Provided on this board 3 is a wiring pattern for power feed to the LED 2. For the board 3, any shape and size are permitted as long as they permits loading of loading members such as the LED 2 and the wavelength conversion member 4, and a thickness may have a strength level that does not cause deformation such as deflection at time of handling.

The wiring pattern formed on the board 3 is formed by, for example, a plating method on an Au surface. The plating method is not limited to use of Au but also use of, for example, Ag, Cu, or Ni. Moreover, Au on a front surface of each pattern part may have a laminated structure of, for example, Au/Ni for the purpose of improving a force of adhesion with the board 3. Note that the wiring pattern may be configured to have its surface subjected to light reflection processing to reflect light emanated from the LED 2 towards the board 3. Moreover, front surfaces of the board 3 and the wiring pattern excluding regions required for the coupling of the wire 31 or the mounting of the LED 2 are preferably covered with white resist. This white resist is formed by, for example, a liftoff process. This protects each pattern part by the white resist, thus improving wiring stability and also making it easy to handle the light-emitting device 1 upon its assembly into the illumination device, which improves manufacturing efficiency of this device.

For the wire 31, for example, a general-purpose metal wire is used. Alternatively, an aluminum wire, a silver wire, a copper wire, or the like may be used. The wire 31 is joined to each electrode of the LED 2 and the wiring pattern on the board 3 through a well-known joining method such as thermal joining or ultrasound joining.

The wavelength conversion member 4 is, as described above including the first phosphor layer 41 and the second phosphor layer 42. Then the second phosphor layer 42 is configured to have higher phosphor concentration than the first phosphor layer 41. Moreover, the first phosphor layer 41 is so formed as to have its outer side surfaces exposed without being coated by the second phosphor layer 42.

The first phosphor layer 41 and the second phosphor layer 42 are obtained by forming into the aforementioned respective shapes a mixed material having an yellow granulous phosphor, which is excited by blue light emanated from the LED 2 to radiate yellow light, dispersed in a translucent resin material (for example, silicone resin). Used for the translucent resin material is, for example, silicone resin with a refractive index of 1.2 and 1.5.

Preferably used for the phosphor is a well-known yellow phosphor which is exited by partially absorbing the blue light emanated from the LED 2 and which has a peak wavelength in a wavelength range of 500 to 650 nm. This yellow phosphor has an emission peak wavelength in a yellow wavelength range and has an emission wavelength range including a red wavelength range. The yellow phosphor is, for example, a so-called YAG phosphor formed of a crystal with a Garnet structure of complex oxide of yttrium and aluminum, but is not limited thereto. For example, for the purpose of adjusting color temperature and color rendering properties, a plurality of phosphors may be mixed, and the red phosphor and the green phosphor can be appropriately mixed to thereby provide white light with high color rendering properties. Note that, for the resin material forming the first phosphor layer 41 or the second phosphor layer 42, in addition to the phosphor described above, for example, a light diffusing material or filler may be added.

Here, of processes of manufacturing the light-emitting device 1, the process of forming the first phosphor layer 41 and the second phosphor layer 42 in particular will be described with reference to Figs. 2(a) to (e). First, as shown in Fig. 2(a), the LED 2 is mounted onto the board 3. Then as shown in Fig. 2(b), a circular frame body 51 is arranged onto the board 3 with a central position of the frame body 51 in agreement with a center of the LED 2. Used as the frame body 51 is the one so formed as to be located at a height equal to a height from the mounting surface of the board 3 to the top surface of the LED 2. Then by using a dispenser 52, a first resin material 41a so adjusted as to reduce the phosphor concentration is poured into the frame body 51. Upon completion of the pouring, part of the first resin material 41a extending beyond the frame body 51 is removed and the first resin material 41a in the frame body 51 is cured. After the curing of the first resin material 41a, between the frame body 51 and the cured first resin material 41a, a release material (not shown) is poured to detach the frame body 51 as shown in Fig. 2(c). As a result, the first phosphor layer 41 is formed. Subsequently, by using a dispenser 53, a second resin material 42a so adjusted as to increase the phosphor concentration is applied to the LED 2 and the top surface of the first phosphor layer 41, and this application is continued while pulling up the dispenser 53. At this point, using a material with relatively high thixotropy for the second resin material 42a makes it easier to form the applied second resin material 42a into a desired shape. After the application, this second resin material 42a is cured. A front surface of the cured second resin material 42a may be, for example, cut or polished into a desired shape. In this manner, the second phosphor layer 42 is formed as shown in Fig. 2(e), thereby manufacturing the light-emitting device 1.

Operation of the light-emitting device 1 will be described with reference to Fig. 1 described above. Light emitted from the LED 2 is emanated radially with the light-guide axis L as a center. Then part of the light hits the phosphor included in the wavelength conversion member 4, turning the phosphor in a ground state into an excited state. The phosphor turned into the excited state discharges light of a wavelength different from that of the light from the LED 2 and returns to the ground state. As a result, the phosphor can radiate the light obtained by converting the wavelength of the light from the LED 2. The light subjected to the wavelength conversion by the phosphor is emanated radially (thus not limited to a direction of the light-guide axis L) from the phosphor. That is, the light radiated from the LED 2 is not only subjected to the wavelength conversion by the phosphor but is also radially diffused without traveling along a direction in which the light travels straight when radiated from the LED 2. Moreover, the light subjected to the wavelength conversion can also be further diffused on a front surface of a different phosphor.

From the LED 2, the blue light emanated laterally enters into the first phosphor layer 41 formed around the LED 2 and part of this light is converted into yellow light by the phosphor. As a result, the blue light and the yellow light are mixed and from side surfaces of the first phosphor layer 41 exposed to the outside, white light is emanated. Here, the phosphor concentration of the first phosphor layer 41 is lower than that of the second phosphor layer 42, and thus compared to light guided to the second phosphor layer 42, light guided to the first phosphor layer 41 is hardly diffused by the phosphor and maintains its directionality when radiated from the LED 2. Therefore, reduction in light beams of the light emanated from the side surfaces of the first phosphor layer 41 can be suppressed, improving illumination intensity for a lateral direction of the light-emitting device 1.

The blue light emanated from the LED 2 towards the light-guide axis L enters into the second phosphor layer 42 formed on the top surface of the LED 2, part of this light is converted into yellow light by the phosphor, and as is the case with the above, white light is emanated from the front surface of the second phosphor layer 42. Here, the phosphor concentration of the second phosphor layer 41 is lower than that of the second phosphor layer 42, and thus compared to light guided to the first phosphor layer 41, light guided to the second phosphor layer 42 can be more easily converted by the phosphor. Therefore, for the light emanated upwardly from the LED 2, a blue light component does not become too intense and is appropriately mixed with a yellow light component, which hardly causes color unevenness on an irradiated surface. In this second phosphor layer 42, light with a large amount of yellow light components is easily emanated in a direction widening laterally to the light-guide direction L. On the other hand, the light emanated from the first phosphor layer 41 described above is likely to have a large amount of blue light components. Thus, the light emanated from the first phosphor layer 41 and the light emanated laterally from the second phosphor layer 42 can be appropriately mixed to thereby emanate, in the lateral direction of the light-emitting device 1, light that hardly causes color unevenness.

Specifically, in the light-emitting device 1, compared to a conventional light-emitting device as shown in Fig. 9, for the light irradiated towards the light-guide axis L, the blue light component is suppressed by the second phosphor layer 42 to thereby suppress the color unevenness. Moreover, for the light irradiated laterally from the LED 2, the yellow light component of the first phosphor layer 41 is reduced to thereby suppress the color unevenness. As a result, the light-emitting device 1 can irradiate light with little color unevenness on the whole. Moreover, from the outer side surfaces of the first phosphor layer 41 exposed to the outside, and from the second phosphor layer 42 with the high phosphor concentration, the light is emanated radially, and thus from the wavelength conversion member 4 including the first phosphor layer 41 and the second phosphor layer 42, light can be irradiated at a wide angle. Moreover, the directivity of the emanated light decreases accordingly, and in an illumination device using this light-emitting device 1, a feeling of granularity specific to the light source of the LED can be reduced. Further, since the outer side surfaces of the wavelength conversion member 4 (first phosphor layer 41) are exposed to the outside and are not surrounded by a reflection mirror or the like, the light is not lost through, for example, multiple reflection, which improves light use efficiency. Moreover, in the light-emitting device 1, the board 3 is flat and the conversion member 4 is formed on the top surface of the board 3, and thus even when LED chip arrangement changes on, for example, a COB module, this light-emitting device 1 can flexibly respond to this change and can be manufactured through the same processes as those described above.

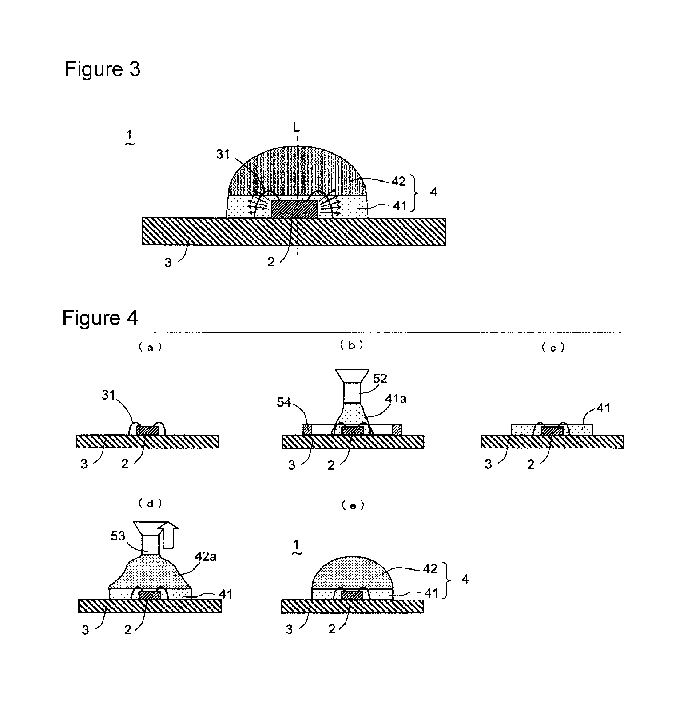

Next, a light-emitting device according to a modified example of the present embodiment will be described with reference to Figs. 3 and 4. The light-emitting device 1 according to this modified example has a first phosphor layer 41 so formed as to slightly cover a top surface of the LED 2. Figs. 4(a) to 4(e) show processes of manufacturing this light-emitting device 1 according to this modified example. Described here is only a point different from that of the embodiment described above (see Figs. 2(a) to 2(e)). The light-emitting device 1 according to this modified example, as shown in Fig. 4(b), in the process of forming the first phosphor layer 41, uses a frame body 54 so formed as to be located at a height slightly higher than a height from a mounting surface of a board 3 to the top surface of the LED 2. As a result, as shown in Fig. 4(c), a position of a top surface of the first phosphor layer 41 can be located slightly higher than a position of the top surface of the LED 2, and the LED 2 is covered by the first phosphor layer 41.

Accumulated in the wavelength conversion member 4 is heat generated when light emanated from the LED 2 was subjected to wavelength conversion. This heat is generated in a greater amount for the second phosphor layer 42 having higher phosphor concentration and also a larger number of light beams than for the first phosphor layer 41. Moreover, the second phosphor layer 42 is also exposed to heat from the LED 2. Then when a temperature of the second phosphor layer 42 turns high, efficiency of conversion by the phosphor may deteriorate, resulting in a risk of failure to emanate light of desired mixed colors. On the other hand, the first phosphor layer 41 has lower phosphor concentration and thus hardly generates heat resulting from the wavelength conversion. Moreover, the first phosphor layer 41 is in contact with the board 3 and thus has favorable heat-dissipating performance and is less likely to have a high temperature compared to the second phosphor layer 42.

With this modified example, an area in which the first phosphor layer 41 and the second phosphor layer 42 make contact with each other is large, and thus heat from the second phosphor layer 42 can efficiently be dissipated to the board 3 via the first phosphor layer 41. Moreover, the LED 2 and the second phosphor layer 42 are not brought into contact with each other, and thus the heat from the LED 2 is hardly transmitted to the second phosphor layer 42, which can suppress a temperature increase of the second phosphor layer 42.

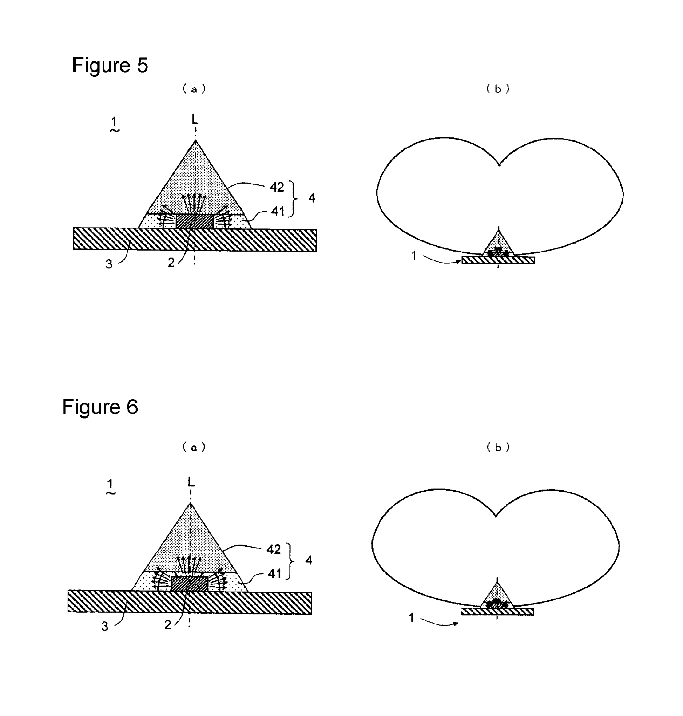

A light-emitting device according to another modified example will be described with reference to Figs. 5 and 6. The light-emitting device 1 according to this modified example, as shown in Fig. 5(a), has a wavelength conversion member 4 formed into a triangular shape in a vertical sectional view.

In this modified example, of light radiated from the LED 2, the light traveling towards a light-guide axis L passes through inside of the wavelength conversion member 4 over a longest distance. Therefore, for the light traveling towards the light-guide axis L, probability of hitting the phosphor increases by a degree corresponding to a long distance in which this light passes through the inside of the wavelength conversion member 4. As a result, in a vertical sectional view of the wavelength conversion member 4, an increase in a longitudinal thickness of the LED 2 compared to a lateral thickness of the LED 2 results in a decrease in an amount of the light traveling towards the light-guide axis L. Further, the light subjected to the conversion by the phosphor is emanated as almost diffusing distributed light (for example, BZ5 of class BZ) to an emanation surface of the wavelength conversion member 4. Therefore, an increase in a ratio of a surface oriented to the side compared to the top results in distribution of light widening laterally.

Thus, the light radiated from the wavelength conversion member 4, as shown in Fig. 5(b), is so radiated as to draw a batwing type distribution curve in which the number of light beams emanated towards the light-guide axis L is small and the number of light beams emanated laterally is large. Therefore, the light-emitting device 1 can widen distribution of the light radiated from the LED 2 and can reduce the directivity specific to the LED light source.

Figs. 6(a) and (b) show still another modified example. In this modified example, as is the case with the modified example shown above in Fig. 3, a first phosphor layer 41 is so formed as to slightly cover a top surface of an LED 2. This modified example provides a light-emitting device 1 providing the effects of both the modified example shown above in Fig. 3 and the modified example shown above in Fig. 5.

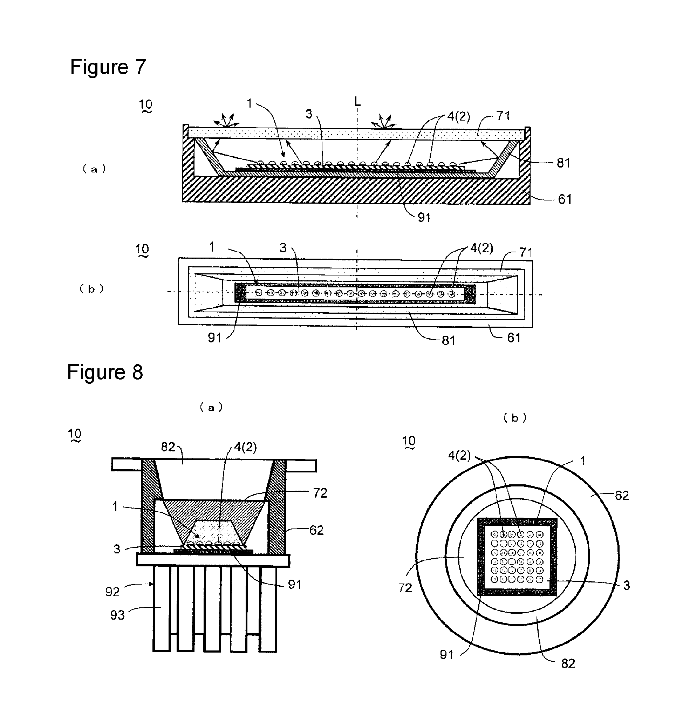

Next, a light-emitting device and an illumination device using the light-emitting device according to a second embodiment of the present invention will be described with reference to Figs. 7(a) and (b). The light-emitting device 1 of the present embodiment has a plurality of LEDs 2 arranged in an array on a board 3 of a long rectangular shape and has the wavelength conversion member 4, shown in the first embodiment above, provided on each LED 2. This light-emitting device 1 is, as shown in the same figure, preferably used for an illumination device 10 of a base light type.

The illumination device 10 includes: a main body part 61; a light-diffusing transmissive panel (hereinafter referred to as light-diffusing panel) 71 that is provided in a light-guide direction of the light-emitting device 1; and a reflection plate 81 that reflects light radiated from the light-emitting device 1 towards the light-diffusing panel 71. Moreover, provided between the light-emitting device 1 and the main body part 61 (the reflection plate 81 in the example illustrated) is a heat-dissipating sheet 91 for effectively dissipating heat of the light-emitting device 1 towards the main body part 61. Note that in the present embodiment, the illustrated illumination device 10 is assumed to be a base light of a long rectangular shape, but it may be of a square or a circular shape and thus no limitation is put on its shape, etc. Moreover, a plurality of light-emitting devices 1 having LEDs 2 arranged in an array may be used, or the LEDs 2 may be arranged in a matrix form on a board 3. Moreover, built in the main body part 61 of the illumination device 10 is a power source unit (not shown) that lights up the light-emitting device 1.

The main body part 61 is a box-shaped structure member with its front open, and includes, in order to store the light-emitting device 1, a bottom part of a rectangular shape that is larger than the board 3; and a side part that is provided upwardly from four corners of the bottom part. Fitted to a circumferential edge on an open side of the side part is a light-diffusing panel 71. Used for the main body part 61 is, for example, an aluminum plate or a plate material such as a steel plate which has predetermined stiffness and which has been subjected to pressing into a predetermined shape. Moreover, its inner side surface may be coated with a white paint or the like.

The light-diffusing panel 71 is a rectangular, plate-like member obtained by forming a milky white material, which has diffusing particles such as titanium oxide added to translucent resin such as acryl resin, into substantially the same shape as an inner dimensional shape of the opening of the main body part 61. Note that the light-diffusing panel 71 may be obtained by performing, for example, sand blast processing on a front surface or a rear surface of a transparent glass plate or a resin plate to form it into a rough surface or performing grain-finishing on the aforementioned surface.

The reflection plate 81 is a reflective plate material that is so arranged as to surround four corners of the LED 2 arranged in an array on the board 3 and the wavelength conversion member 4 and also as to tilt with respect to a light-guide axis L. Preferably used for this reflection plate 81 is, for example, a light-diffusing reflection plate manufactured by applying a reflective white paint to a resin structure formed into the abovementioned shape. Note that in the case where the illumination device 10 is used as, for example, a down light, preferably used is a reflection plate having highly reflective silver or aluminum deposited on its surface.

The heat-dissipating sheet 91 is a sheet-like member formed of a material having epoxy resin filled with a high concentration of filler such as alumina or silica. This heat-dissipating sheet 91 is so formed as to have insulation properties and also as to be mixed with the filler described above to have relatively high heat conductivity (for example, approximately 3W/m×K). Moreover, the heat-dissipating sheet 91 has a sheet thickness of approximately 100µm and has a property such that it has low viscosity when heated. Thus, compared to other typical rubber-type heat-dissipating sheets, a sheet thickness can be thinned, resulting in small thermal resistance, which permits efficient heat dissipation to the main body part 61.

In the illumination device 10 configured as described above, light radiated from the light-emitting device 1 enters the light-diffusing panel 71 directly or after reflected by the reflection plate 81, and is emanated to outside of the illumination device 10. At this point, even in the case where the light-diffusing panel 71 is arranged closely to the light-emitting device 1, the light-emitting device 1 radiates the light at a wide angle as described in the first embodiment above, thus resulting in low directivity of the light entering the light-diffusing panel 71. This light is further diffused by the light-diffusing panel 71 to be emanated. Therefore, the illumination device 10 can have the entire light-diffusing panel 71 appear shiny and provide even luminance distribution of the light-diffusing panel 71. Moreover, as is the case with the luminance unevenness, color unevenness can also be reduced, and thus the light-diffusing panel 71 can be arranged closely to the light-emitting device 1, which permits slimming of the illumination device 10. Further, on an emanation surface of the light-diffusing panel 71 of the illumination device 10, a feeling of glanularity specific to a light source of the LED 2 can be suppressed, which can reduce glare.

A light-emitting device and an illumination device using the light-emitting device according to a modified example of the second embodiment will be described with reference to Figs. 8(a) and (b). The light-emitting device 1 according to this modified example has a plurality of LEDs 2 arranged in an array on a board 3 of a circular shape, and has the wavelength conversion member 4, shown in the first embodiment above, on each LED 2. This light-emitting device 1, as shown in the same figure, is preferably used for a down-light type illumination device 10.

The illumination device 10 includes: a frame main body 62 for holding the illumination device 10 in an opening formed on a worked surface (for example, the ceiling); a condensing lens 72 that condenses light emanated from the light-emitting device 1; and a reflection member 82 that controls distribution of light emanated from the condensing lens 72. Moreover, the illumination device 10 includes: a heat sink member 92 that is fitted to a rear side of the illumination device 10 and dissipates heat of the light-emitting device 1; and a heat-dissipating sheet 91 that is provided between the light-emitting device 1 and the heat sink member 92 for effectively dissipating heat of the light-emitting device 1 to the heat-dissipating fin 92.

The frame main body 62 is a cylindrical member having an opening for guiding light and has a circumferential edge of the opening formed with a shoulder part that engages with an opening of a worked surface. This frame main body 62 is formed of the same material as that of the main body part 61 of the embodiment described above. Provided on an inner side surface of a cylindrical part of the frame main body 62 is a craw part that holds the condensing lens 72. To a portion extending from this craw part to the opening part, for example, an optically reflective metal material is deposited through deposition, and this functions as the reflection member 82. A shape of the reflection member 82 is so designed to permit control of an irradiation angle of the illumination device 10 at a predetermined angle.

The condensing lens 72 is obtained by subjecting a light translucent material such as transparent acryl resin into a cylindrical shape provided with a bottom. A compound lens may be used which includes a combination of a plurality of lens members in correspondence with an installation position of the LED 2. This condensing lens 72 is desirably so formed as to be diffusive as a result of performing, for example, dimple processing on a light-emanation surface of the lens so that a yellow ring by the LED 2 is not reflected on an irradiated surface.

For the heat-dissipating sheet 91, the one the same as that of the embodiment described above is used and it is formed into a circular shape in correspondence with a shape of the board 3.

The heat sink member 92 is formed of, for example, an aluminum alloy and a general-purpose aluminum die cast is preferably used. Formed on an outer circumferential surface of this heat sink member 92 are a plurality of heat-dissipating fins 93 for increasing an area of a front surface making contact with outside air to thereby improve heat-dissipating performance. Moreover, provided at inner circumference of the heat sink member 92 is a space for storing a power source unit (not shown) that lights up the light-emitting device 1.

Also in this modified example, the light-emitting device 1 can radiates light at a wide angle, and thus when the condensing lens 72 and the reflection member 82 are used, for example, their shapes, etc. can be adjusted to thereby realize an illumination device 10 with high light distribution control performance.

The present invention is not limited to the embodiments described above, and various modifications can be made to the present invention. For example, illustrated in the second embodiment described above is an example in which the wavelength conversion member 4 is provided for each of the plurality of LEDs 2 arranged in an array, but the plurality of LEDs 2 may be coated with one wavelength conversion member 4. At this point, the wavelength conversion member 4 is formed into, for example, a tub-like shape, but as long as the first phosphor layer 42 is formed in a direction orthogonal to a longitudinal direction of the wavelength conversion member 4, at least for characteristic of light emission along this direction, the same effects as provided by the embodiments described above can be expected.

### [Description of Reference Numerals]

- 1: Light-emitting device
- 10: Illumination device
- 2: LED (solid light-emitting element)
- 3: Board
- 4: Wavelength conversion member
- 41: First phosphor layer
- 42: Second phosphor layer

## Claims

1. A light-emitting device comprising:
a solid light-emitting element;
a board having the solid light-emitting element mounted thereon;
and
a wavelength conversion member formed in a manner such as to include a phosphor in a transparent resin member coating a light-emission surface of the solid light-emitting element, wherein
the wavelength conversion member has: a first phosphor layer provided around the solid light-emitting element in a manner such as to be located at substantially the same height as that of a top surface of the solid light-emitting element; and a second phosphor layer provided in a manner such as to coat the solid light-emitting element and the first phosphor layer,
the second phosphor layer is formed in a manner such as to have higher concentration of the phosphor than the first phosphor layer, and
the first phosphor layer is formed in a manner such as to have an outer side surface thereof exposed without being coated with the second phosphor layer.

2. The light-emitting device according to claim 1, wherein
the first phosphor layer is formed in a manner such as to slightly cover the top surface of the solid light-emitting element.

3. The light-emitting device according to claim 1 or 2, wherein
the wavelength conversion member is formed in a manner such as to be triangular-shaped in a vertical sectional view.

4. An illumination device using the light-emitting device according to any one of claims 1 to 3.
